# DEMANDE DE BREVET EUROPEEN

(11) **EP 4 495 855 A1**
(43) Date de publication de la demande: **22.01.2025**
(21) Numéro de dépôt: 24189354.4
(22) Date de dépôt: 18.07.2024
(51) Int. Cl.: G06Q 10/0633, B66C 1/40, B66C 13/16, G06Q 50/08

(54) **PROCÉDÉ AUTOMATISÉ POUR ÉTABLIR UN INVENTAIRE DES TRAVAUX RÉALISÉS PAR UN ENGIN DE LEVAGE**

(30) Priorité: 20.07.2023 FR 2307776
(71) Demandeur: Manitowoc Crane Group France, 69570 Dardilly (FR)
(72) Inventeur: BUCAS, Simon, 69002 Lyon (FR); LARMINIER, Nicolas, 69003 LYON (FR); JUSSEY, Thomas, 69600 OULLINS (FR)
(74) Mandataire: Germain Maureau

(57) **Abrégé**

Procédé (100) automatisé pour établir un inventaire des catégories de travaux (T1, T2, T3, T4, T5, T6) réalisés pendant différentes périodes de temps par un engin de levage (E), le procédé comprenant les étapes suivantes :
- une étape de collecte (101) pendant au moins une période de temps, par une unité de collecte (UC), des informations en provenance d'une unité de contrôle-commande (C2) de l'engin de levage (E) ;
- une étape de traitement (103) des informations collectées pour déterminer un travail réalisé par l'engin de levage (E) pendant l'au moins une période de temps, le travail réalisé relevant d'au moins une catégorie de travail (T1, T2, T3, T4, T5, T6), et pour déterminer au moins un paramètre associé à l'au moins un travail réalisé et/ou à l'au moins une catégorie de travail réalisé (T1, T2, T3, T4, T5, T6).

## Description

La présente invention concerne le domaine des travaux de construction et de génie civil, et en particulier le suivi de l'avancement technique des chantiers dans lesquels sont présents des engins de levage, et plus particulièrement des grues.

Il peut arriver que l'avancement de certains chantiers de construction diverge fortement des prévisions initiales. Dans ce cas, il arrive que des chrono-analyses manuelles soient réalisées afin d'essayer de réorganiser le travail restant pour rattraper le retard. Ces chrono-analyses nécessitent le déplacement d'au moins une personne sur le chantier sur une période allant d'un à plusieurs jours. De plus, il est impossible d'effectuer ces chrono-analyses manuelles de manière systématique sur tous les chantiers. De ce fait, un outil automatisé pour le suivi de l'avancement des travaux réalisés présente un avantage certain pour les chantiers.

L'invention a donc pour but de proposer une solution à tout ou partie de ces problèmes.

A cet effet, la présente invention concerne un procédé automatisé pour établir un inventaire des catégories de travaux réalisés pendant différentes périodes de temps par un engin de levage, le procédé comprenant les étapes suivantes :
- une étape de collecte pendant au moins une période de temps, par une unité de collecte, d'informations en provenance d'une unité de contrôle-commande de l'engin de levage;
- une étape de traitement, par une unité de traitement locale et/ou une unité de traitement distante, des informations collectées par l'unité de collecte, pour déterminer un travail réalisé par l'engin de levage pendant l'au moins une période de temps, le travail réalisé relevant d'au moins une catégorie de travail réalisé, et pour déterminer au moins un paramètre associé à l'au moins un travail réalisé et/ou à l'au moins une catégorie de travail réalisé, l'étape de traitement comprenant une mise en oeuvre par l'unité de traitement locale et/ou l'unité de traitement distante d'un algorithme d'intelligence artificielle entraîné au cours d'une phase d'apprentissage pour réaliser au cours d'une phase prédictive de l'étape de traitement, l'algorithme d'intelligence artificielle utilisant au moins une information contextuelle pour déterminer le travail réalisé et/ou la catégorie de travail réalisé, l'information contextuelle étant l'une parmi au moins un temps de levage, une charge maximale, une vitesse maximale, une position d'un point de prise de la charge et une position d'un point de dépose de la charge, une localisation d'un point de livraison, une localisation d'une zone de stockage.

Ainsi, la présente invention se propose d'exploiter un engin de levage, présent sur un chantier, pour récupérer des données et en particulier des informations provenant de l'unité de contrôle-commande de l'engin de levage, par exemple de manière continue, qui seront exploitées afin d'établir un ou plusieurs paramètres exploitables pour établir l'activité réelle de l'engin de levage et ainsi l'avancement du chantier; l'engin de levage étant généralement un élément majeur du chantier, au coeur de la plupart des opérations/travaux, tels que non limitativement des travaux de coulée de béton, de portage d'éléments de structure (poutres, prémurs, etc.), etc. L'avantage de l'invention réside ainsi dans cette exploitation des données issues de l'unité de contrôle-commande de l'engin de levage, c'est-à-dire de données issues d'une unité présente nativement sur l'engin de levage, pour le suivi de l'avancement des travaux réellement réalisés, avant une éventuelle comparaison avec les travaux planifiés, de manière à pouvoir évaluer de manière fiable un retard. Ainsi, l'invention ne nécessite pas la présence et/ou l'intégration de capteurs supplémentaires sur l'engin de levage. De plus, l'invention ne nécessite pas l'utilisation de données externes au chantier concerné. En définitive, l'invention, en tirant profit du matériel existant sur l'engin de levage pour extraire les informations nécessaires, est simple et peu coûteuse à mettre en oeuvre, et ne nécessite pas l'ajout de matériel supplémentaire (capteurs supplémentaires ou autres) sur l'engin de levage.

Selon un mode de mise en oeuvre, l'invention comprend une ou plusieurs des caractéristiques suivantes, seules ou en combinaison techniquement acceptable.

Selon un mode de mise en oeuvre, les informations collectées comprennent au moins l'un parmi un signal de charge, représentatif d'une masse d'une charge levée par l'engin de levage, un signal de position dans l'espace d'un crochet de l'engin de levage, un signal de vitesse représentatif d'une variation des variateurs de fréquence et un signal représentatif d'un état électrique de l'engin de levage tel qu'un état allumé ou activé dans lequel l'engin de levage est allumé (on), un état désactivé ou éteint dans lequel l'engin de levage est éteint (off), un état de veille dans lequel l'engin de levage est en mode de veille, un état indiquant un démarrage en cours ou encore un état indiquant une extinction en cours.

Selon une possibilité, l'état électrique de l'engin de levage est fourni par l'unité de contrôle commande de l'engin de levage.

Selon une possibilité, une allure d'un signal de charge issu de l'étape de collecte est comparée à au moins une allure de signal de charge modèle, ou allure type, obtenue lors de la phase d'apprentissage de l'algorithme d'intelligence artificielle, ladite allure de signal de charge modèle étant représentative d'une catégorie de travail réalisé.

Selon cette possibilité, la comparaison de l'allure du signal de charge issu de l'étape de collecte à au moins une allure de signal de charge modèle permet d'identifier un travail réalisé ou une catégorie de travail réalisé par l'engin de levage.

Selon un mode de mise en oeuvre, un signal de charge issu de l'étape de collecte est comparé à un ensemble de signaux modèles déterminés par une phase d'apprentissage de l'algorithme d'intelligence artificiel.

Selon une possibilité, la création de ces signaux modèles et leur mise en oeuvre se basent sur une distance entre les signaux obtenus par une déformation dynamique temporelle permettant de créer les signaux modèles et par la suite la catégorie de travail réalisé par l'engin de levage.

Selon une possibilité, le signal de charge obtenu à l'étape de collecte est préalablement découpé en un certain nombre de cycles de levage bornés dans le temps, c'est-à-dire représenté par un début de levage et une fin de levage.

Selon une possibilité, le découpage du signal de charge, qui permet d'extraire les différents cycles de levage, est réalisé au moyen d'un algorithme déterministe, par exemple

La déformation temporelle dynamique utilisée à l'étape d'apprentissage permet donc de réaliser l'étape de comparaison, l'étape d'apprentissage permettant de définir les différentes catégories de travail réalisé en fonction de l'allure du signal de charge tandis qu'à l'étape de comparaison, le cycle de levage identifié, c'est-à-dire borné par un début et une fin de levage, et normalisé est comparé via la déformation temporelle dynamique au centroïde (représentant un cycle moyenné pour la catégorie considérée) de chacune des catégories de travail.

Selon un mode de mise en oeuvre, l'au moins une catégorie de travail réalisé pendant l'au moins une période de temps comprend au moins l'une parmi un coulage de béton, un transfert d'un type de charge, un positionnement d'un type de charge, un mouvement à vide, un déchargement d'un camion de matériaux.

Selon un mode de mise en oeuvre, l'au moins une catégorie de travail réalisé pendant l'au moins une période de temps sera une catégorie indéfinie, ou une période d'inactivité.

Selon un mode de mise en oeuvre, le type de charge comprend au moins l'une parmi une benne à béton, une benne à gravats, un ou plusieurs matériels de construction, un ou plusieurs éléments de coffrage, un ou plusieurs éléments de ferraillage de béton, un élément préfabriqué.

Selon un mode de mise en oeuvre, le matériel de construction comprend au moins l'un parmi un groupe d'étais, un coffrage de mur, i.e. une banche, des éléments de coffrage de plancher.

Selon un mode de mise en oeuvre, l'élément préfabriqué comprend au moins l'un parmi un escalier, un balcon, un prémur.

Selon un mode de mise en oeuvre, l'au moins un paramètre associé à l'au moins une catégorie de travail réalisé comprend au moins l'un parmi une durée d'un travail réalisé relevant de ladite au moins une catégorie de travail, une masse d'une charge levée au cours d'un travail réalisé relevant de l'au moins une catégorie de travail, un mouvement d'une charge levée au cours d'un travail réalisé relevant de l'au moins une catégorie de travail, une durée moyenne des travaux réalisés, pendant différentes périodes de temps, relevant de ladite catégorie de travail, une durée maximum des travaux réalisés, pendant différentes périodes de temps, relevant de ladite catégorie de travail, une durée minimum des travaux réalisés, pendant différentes périodes de temps, relevant de ladite catégorie de travail, une masse minimum levée au cours des travaux réalisés, pendant différentes périodes de temps, relevant de ladite catégorie de travail, une masse maximum levée au cours des travaux réalisés, pendant différentes périodes de temps, relevant de ladite catégorie de travail.

Selon un mode de mise en oeuvre, l'algorithme d'intelligence artificielle est entraîné en outre pour classer l'au moins un travail réalisé déterminé au cours de l'étape de traitement selon au moins une catégorie de travail.

Selon un mode de mise en oeuvre, l'au moins un paramètre associé au travail réalisé est utilisé au cours de l'étape de traitement pour déterminer au moins un autre paramètre associé à l'au moins une catégorie de travail.

Selon un mode de mise en oeuvre, l'information contextuelle est au moins l'un parmi une localisation d'un point de livraison du béton par un camion toupie, une localisation d'un point de livraison de matériels ou d'une matière première par un camion de livraison, une localisation d'un point de stockage de matériels ou d'une matière première livrée par un camion de livraison.

Selon un mode de mise en oeuvre, l'information contextuelle est associée à l'au moins un paramètre déterminé au cours de l'étape de traitement.

Selon un mode de mise en oeuvre, l'étape de traitement produit une description des travaux réalisés par l'engin de levage, la description prenant au moins une forme parmi un graphique représentant l'au moins un travail réalisé, selon la catégorie du travail réalisé, en fonction d'un temps représenté selon un axe du temps, un diagramme de type camembert représentatif d'une importance relative de l'au moins un paramètre associé à l'au moins une catégorie du travail, un tableau récapitulatif de valeurs de l'au moins un paramètre associé à l'au moins une catégorie de travail, une représentation en trois dimensions d'un point de début et de fin d'au moins un travail réalisé relevant d'au moins une catégorie de travail.

Selon un mode de mise en oeuvre, le procédé comprend en outre une étape de comparaison de l'au moins un travail réalisé relevant de l'au moins une catégorie de travail réalisé avec au moins un travail prévu, afin de déterminer un écart entre l'au moins un travail réalisé et l'au moins un travail prévu.

Selon un mode de mise en oeuvre, l'étape de traitement des informations collectées est réalisée localement sur l'engin de levage.

Selon un mode de mise en oeuvre, le procédé comprend en outre une étape de transmission des informations collectées à une unité de traitement distante disposée sur un serveur distant et configurée pour mettre en oeuvre l'étape de traitement des informations collectées.

Selon un mode de mise en oeuvre, le procédé comprend en outre une étape de transmission, à une unité d'affichage disposée localement sur l'engin de levage, de la description de l'au moins un travail réalisé produite au cours de l'étape de traitement, pour permettre un affichage et un suivi local des travaux réalisés.

Selon un mode mise en oeuvre, l'étape de traitement est réalisée localement sur l'unité de traitement locale de l'engin de levage ou sur ladite unité de traitement distante disposée sur le serveur distant.

Selon un mode mise en oeuvre, l'étape d'affichage est réalisée localement sur l'unité d'affichage de l'engin de levage ou sur une unité d'affichage distante et par exemple associée au serveur distant.

Selon un aspect, l'invention concerne un système de levage comprenant un engin de levage et un serveur distant, l'engin de levage comprenant une unité de contrôle-commande de l'engin de levage, l'engin de levage comprenant en outre une unité de collecte configurée pour collecter pendant au moins une période de temps des informations en provenance de l'unité de contrôle-commande de l'engin de levage, l'unité de collecte étant configurée pour transmettre les informations collectées à une unité de traitement distante, disposée sur le serveur distant, l'unité de traitement distante étant configurée pour réaliser un traitement des informations collectées pour déterminer un travail réalisé par l'engin de levage pendant l'au moins une période de temps, le travail réalisé relevant d'au moins une catégorie de travail, et pour déterminer au moins un paramètre associé à l'au moins un travail réalisé et/ou à l'au moins une catégorie de travail réalisé, ledit traitement comprenant une mise en oeuvre par l'unité de traitement distante d'un algorithme d'intelligence artificielle entraîné au cours d'une phase d'apprentissage pour réaliser au cours d'une phase prédictive ledit traitement, l'algorithme d'intelligence artificielle utilisant au moins une information contextuelle pour déterminer le travail réalisé et/ou la catégorie de travail réalisé, l'information contextuelle étant au moins l'une parmi un temps de levage, une charge maximale, une vitesse maximale, une position d'un point de prise de la charge et une position d'un point de dépose de la charge, une localisation d'un point de livraison, une localisation d'une zone de stockage.

Selon un autre aspect, l'invention concerne un engin de levage, comprenant une unité de contrôle-commande de l'engin de levage et une unité de traitement locale disposée sur l'engin de levage, l'engin de levage comprenant en outre une unité de collecte configurée pour collecter pendant au moins une période de temps des informations en provenance de l'unité de contrôle-commande de l'engin de levage, l'unité de collecte étant configurée pour transmettre les informations collectées à l'unité de traitement locale, disposée sur l'engin de levage, l'unité de traitement locale étant configurée pour réaliser un traitement des informations collectées pour déterminer un travail réalisé par l'engin de levage pendant l'au moins une période de temps, le travail réalisé relevant d'au moins une catégorie de travail, et pour déterminer au moins un paramètre associé à l'au moins un travail réalisé et/ou à l'au moins une catégorie de travail réalisé, ledit traitement comprenant une mise en oeuvre par l'unité de traitement d'un algorithme d'intelligence artificielle entraîné au cours d'une phase d'apprentissage pour réaliser au cours d'une phase prédictive ledit traitement, l'algorithme d'intelligence artificielle utilisant au moins une information contextuelle pour déterminer le travail réalisé et/ou la catégorie de travail réalisé, l'information contextuelle étant au moins l'une parmi un temps de levage, une charge maximale, une vitesse maximale, une position d'un point de prise de la charge et une position d'un point de dépose de la charge, une localisation d'un point de livraison, une localisation d'une zone de stockage.

Selon un mode de réalisation, l'unité de traitement locale et/ou l'unité de traitement distante est/sont en outre configurée(s) pour produire une description des travaux réalisés par l'engin de levage.

Pour sa bonne compréhension, un mode de réalisation et/ou de mise en oeuvre de l'invention est décrit en référence aux dessins ci-annexés représentant, à titre d'exemple non limitatif, une forme de réalisation ou de mise en oeuvre respectivement d'un dispositif et/ou d'un procédé selon l'invention. Les mêmes références sur les dessins désignent des éléments similaires ou des éléments dont les fonctions sont similaires.
[Fig. 1a] est une première vue schématique et simplifiée d'un engin de levage sur un site de construction, configuré pour la mise en oeuvre du procédé selon l'invention
[Fig.1b] est une deuxième vue schématique et détaillée de l'engin de levage de la figure 1a
[Fig. 2] est un diagramme simplifié de la séquence des étapes du procédé selon l'invention
[Fig. 3] est un exemple de chronogramme produit par le procédé selon l'invention, dans lequel sont représentés en fonction d'un temps, le long d'un axe du temps T, les différentes catégories de travaux réalisées par l'engin de levage, chaque catégorie de travail réalisé étant représentée par une couleur particulière.
[Fig. 4] est un exemple de représentation d'une répartition des différentes catégories de travaux réalisées par l'engin de levage, la répartition étant déterminée sur la base d'une métrique ou d'un paramètre particulier, tel qu'une durée du travail réalisé, un nombre de levage réalisé, ou une durée des mouvements de l'engin de levage.
[Fig. 5] est un exemple de représentation en trois dimensions des positions dans l'espace des points de début et de fin des travaux réalisés.
[Fig. 6] représente une phase de collecte de différents signaux de charge correspondant à différents engins de levage présents sur différents chantiers.
[Fig.7] représente trois allures de signal de charge respectivement représentatives de trois catégories de travail réalisé
[Fig.8] représente une phase de transmission, aux unités de traitement locales des engins de levage, des différentes allures de signal de charge déterminées [Fig.9] représente schématiquement, pour un unique engin de levage présent sur un chantier donné, la phase de collecte représentée figure 6 et la phase de transmission représentée figure 8

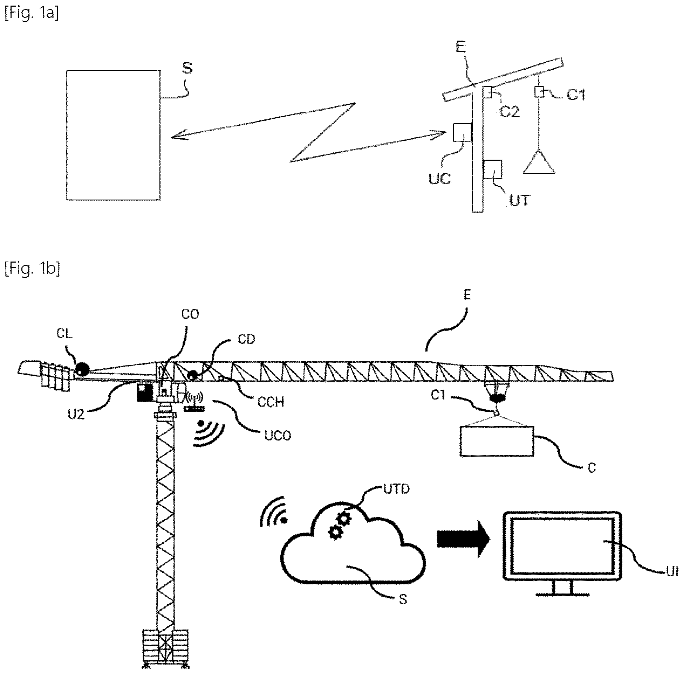

L'invention concerne un procédé 100 pour déterminer automatiquement les travaux réalisés par un engin de levage E, par exemple une grue, représentée schématiquement à titre d'exemple sur les figures 1a et 1b. L'engin de levage E comprend une unité de contrôle-commande C2 configurée pour communiquer avec différents capteurs installés sur l'engin de levage E ; par exemple, les différents capteurs comprennent un capteur de mesure de charge CCH, c'est-à-dire un capteur de mesure d'une masse d'une charge C levée par un crochet C1 de l'engin de levage E, et des capteurs de positionnement des parties mobiles de l'engin de levage E comme par exemple un codeur de levage CL, un codeur d'orientation CO ou encore un codeur de distribution CD.

Le codeur de levage CL donne une image de la hauteur du crochet de levage de l'engin de levage.

Le codeur de distribution CD donne une image de la position du chariot, et donc du crochet de levage de l'engin de levage, par rapport à son axe de rotation entre sa partie fixe (mature) et sa partie tournante.

Le codeur d'orientation CO donne une image de l'angle de la partie tournante de l'engin de levage par rapport à un angle de référence de sa partie fixe (mature). L' unité de contrôle-commande C2 est en outre configurée pour commander la mise en oeuvre de l'engin de levage E, en fonction notamment des mesures rendues par lesdits capteurs, pour la réalisation, pendant différentes périodes de temps, de différentes catégories de travaux T1, T2, T3, T4, T5, T6, tels que par exemple un coulage de béton, un transfert ou un positionnement d'un type de charge, un mouvement à vide, ou autre, par exemple un déchargement d'un camion de matériaux, optionnellement, on considérera également parmi les catégories de travaux réalisées, des périodes d'inactivité ou des périodes d'activité indéfinie.

Plus particulièrement, le type de charge comprend une benne à béton, une benne à gravats, un ou plusieurs matériels de construction, par exemple un groupe d'étais, un ou plusieurs éléments de coffrage (aussi appelés banches), un ou plusieurs éléments de ferraillage de béton, un élément préfabriqué, par exemple un escalier, un balcon, un prémur.

L'engin de levage E comprend en outre unité de collecte UC configurée pour capter différents signaux utilisés par l'unité de contrôle-commande C2 pour mettre en oeuvre et commander l'engin de levage E au fur et à mesure de la réalisation des différentes catégories de travaux.

Les informations ainsi collectées par l'unité de collecte UC comprennent notamment un signal de charge, représentatif d'une masse de la charge C levée par l'engin de levage E au cours du temps, un signal de position dans l'espace d'un crochet C1 de l'engin de levage E, un signal de vitesse représentatif d'une variation des variateurs de fréquence et un signal représentatif d'un état électrique de l'engin de levage E. Cette liste n'est pas exhaustive.

Les informations collectées sont fournies en entrée d'une unité de traitement locale UT et/ou d'une unité de traitement distante UTD. L'unité de traitement distante UTD peut être disposée sur un serveur distant S, avec lequel l'unité de collecte UC est configurée pour communiquer par l'intermédiaire d'une unité de communication UCO de l'engin de levage E apte à transmettre et recevoir des informations échangées par exemple sur un réseau étendu tel que internet. L'unité de traitement locale UT peut être installée localement à proximité de ou directement sur l'engin de levage E, l'unité de collecte UC étant configurée pour communiquer avec l'unité de traitement locale UT via une liaison avec ou sans fil.

L'unité de traitement locale UT et/ou l'unité de traitement distante UTD est/sont configurée(s) pour mettre en oeuvre un algorithme d'intelligence artificielle entraîné pour déterminer à partir des informations collectées par l'unité de collecte UC, une catégorie de travail réalisé par l'engin de levage E, par exemple un coulage de béton, un déplacement d'un type de charge, un transfert d'un type de charge ou un déchargement d'un camion de matériaux, et pour déterminer différents paramètres associés à la catégorie du travail réalisé, par exemple une durée dudit travail réalisé, une masse d'une charge levée au cours dudit travail réalisé, un mouvement d'une charge levée au cours de ladite catégorie de travail réalisé ; l' algorithme d'intelligence artificielle est entraîné pour déterminer également, à partir des informations collectées pendant différentes périodes de temps, une distance parcourue, et une vitesse de déplacement associée, entre le point de prise de la charge et le point de dépose, ou une durée moyenne des travaux réalisés relevant de ladite catégorie de travaux, ou une durée maximum des travaux réalisés relevant de ladite catégorie de travaux, ou une durée minimum des travaux réalisés relevant de ladite catégorie de travaux, ou une masse minimum levée au cours des travaux réalisés relevant de ladite catégorie de travaux, ou une masse maximum levée au cours des travaux réalisés relevant de ladite catégorie de travaux.

L'algorithme d'intelligence artificielle est par exemple mis en oeuvre par un algorithme de groupement par analyse temporelle non supervisé compris dans l'unité de traitement locale UT et/ou l'unité de traitement distante UTD.

L'apprentissage de l'algorithme d'intelligence artificielle peut être réalisé à partir d'un jeu de données d'apprentissage, collectées via l'unité de collecte UC; une phase de nettoyage, normalisation et regroupement des informations collectées par allure et tendance via une déformation temporelle dynamique, est prévue avant l'apprentissage de l'algorithme d'intelligence artificielle, afin d'améliorer les résultats de l'apprentissage.

L'algorithme d'intelligence artificiel mis en oeuvre se base par exemple sur une allure, i.e. sur une forme ou une "tête", du signal temporel de charge ; cela a l'avantage d'être simple et assez peu coûteux en temps de calcul.

Selon un exemple de mise en oeuvre, afin de réduire la proportion d'erreur de classification des travaux réalisés, i.e. la proportion des cycles de levage qui ne sont pas classés dans la catégorie de travail réalisé attendue, par exemple un coulage de béton détecté comme un positionnement de préfabriqué, l'algorithme d'intelligence artificielle est enrichi avec des données contextuelles relatives à ces caractéristiques intrinsèques. Selon un exemple de prise en considération de données contextuelles par l'algorithme d'intelligence artificielle, lorsqu'il est connu que le camion toupie livre le béton en un point de livraison connu par sa localisation, l'algorithme d'intelligence artificielle utilise cette information contextuelle pour en déduire qu'un cycle de levage qui commence ou se termine à proximité de cette localisation connue correspond à un cycle du coulage. Selon un autre exemple de prise en considération de données contextuelles par l'algorithme d'intelligence artificielle, lorsqu'il est connu que des camions de livraison se garent en un autre point de livraison connu, que les matériels ou les matières premières livrées sont stockés en une zone de stockage de localisation connue, l'algorithme d'intelligence artificielle utilise ces informations contextuelles, localisation connue de l'autre point de livraison et localisation connue de la zone de stockage, pour en déduire qu'un cycle de levage dont le point de prise de charge correspond à la localisation connue de l'autre point de livraison, et dont le point de dépose correspond à la localisation connue de la zone de stockage, correspond à un travail de type "déchargement de camion".

Ainsi, l'algorithme d'intelligence artificielle peut prendre en compte différentes données contextuelles associées à différentes caractéristiques d'un cycle de levage, telles qu'un temps de levage, une charge maximale, une vitesse maximale, une position d'un point de prise de la charge et une position d'un point de dépose de la charge.

Ainsi, le procédé 100 permet la détermination automatisée des types d'activité, i.e des catégories de travaux T1, T2, T3, T4, T5, T6, réalisées par l'engin de levage E, avec leur durée, les déplacements associés, la charge levée, etc.

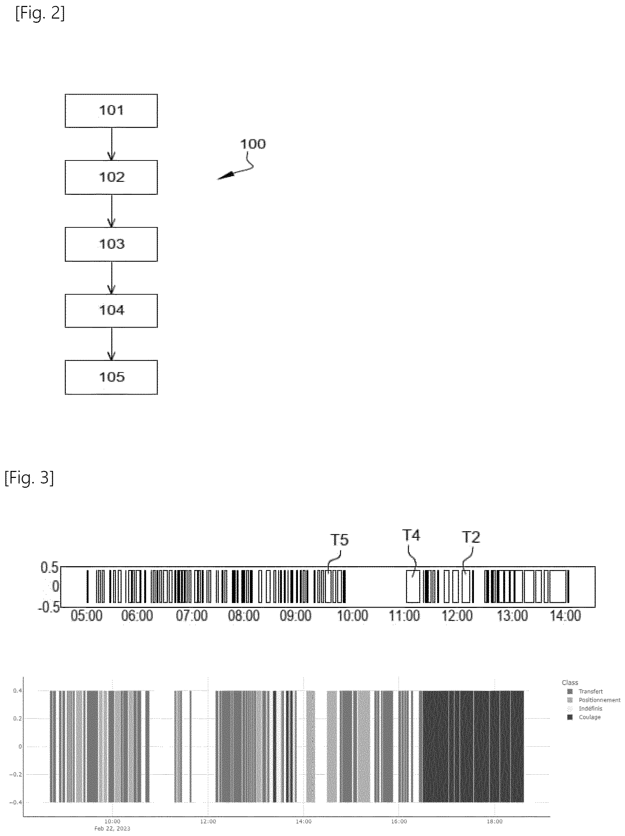

En référence à la figure 2, le procédé 100 comprend les étapes suivantes :
- une étape de collecte 101 pendant au moins une période de temps, par une unité de collecte UC, des informations en provenance d'une unité de contrôle-commande C2 de l'engin de levage E ;
- une étape de traitement 103 les informations collectées par l'unité de collecte UC pour déterminer un travail réalisé par l'engin de levage E pendant l'au moins une période de temps, le travail réalisé relevant d'au moins une catégorie de travail réalisé T1, T2, T3, T4, T5, T6, et pour déterminer au moins un paramètre associé à l'au moins un travail réalisé et/ou à l'au moins une catégorie de travail réalisé T1, T2, T3, T4, T5, T6.

Optionnellement, le procédé 100 comprend en outre une étape de transmission 102 des informations collectées à l'unité de traitement distante UTD disposée sur le serveur distant S et configurée pour mettre en oeuvre l'étape de traitement 103 des informations collectées. Selon une autre option, l'étape de traitement 103 des informations collectées est réalisée localement sur l'unité de traitement locale UT de l'engin de levage E.

Le tableau ci-dessous illustre à titre d'exemple les informations que le procédé 100 selon l'invention permet de déterminer automatiquement à partir des informations de contrôle-commande collectées via l'unité de collecte UC.

**[Tableau 1]**

| Catégorie de travail réalisé | Nombre de levages | Durée totale | Durée moyenne | Durée maximale | Charge moyenne (kg) | Charge maximale (kg) |
|---|---|---|---|---|---|---|
| Transfert : T1 | 339 | 10 :46 :40 | 00 :02 :45 | 00 :10 :15 | 1245 | 5642,5 |
| Positionnement : T2 | 134 | 06 :17 :06 | 00 :07 :50 | 00 :18 :52 | 1859 | 4221,25 |
| Coulage : T5 | 30 | 03 :55 :16 | 00 :04 :13 | 00 :10 :49 | 888 | 3437,5 |
| Indéfini : T4 | 14 | 00 :59 :14 | | | | |
| Inactif : T3 | | 3 :29 :56 | | | | |
| Mouvements à vide :T6 | | 5 :24 :14 | | | | |
| Autre | | 9 :17 :36 | | | | |

Le nombre de catégories de travaux, et la « finesse » de ces catégories, est directement lié au nombre de paramètres, déterminés au cours de l'étape de traitement 103 des informations collectées, et pris en compte pour la détermination et la catégorisation des travaux réalisés dès lors qu'on trouve suffisamment de paramètres contextuels pour différentier une classe d'une autre classe.

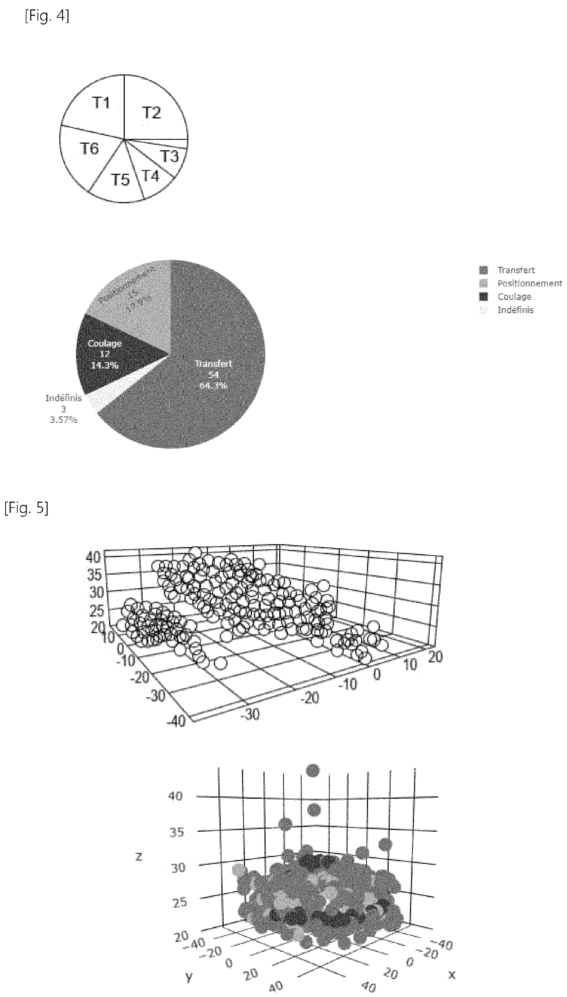

Selon un exemple de mise en oeuvre, l'étape de traitement 103 est configurée pour produire une description des travaux réalisés par l'engin de levage E, la description prenant la forme d'un graphique ou chronogramme représentant lesdits travaux réalisés présentés chronologiquement, par exemple par code de couleur, selon un axe temporel T, comme cela est illustré sur la figure 3; la description peut également prendre la forme d'un diagramme de type camembert représentatif d'une importance relative de la valeur d'un paramètre particulier, par exemple une durée du travail, associé auxdits travaux réalisés T1, T2, T3, T4, T5, T6, comme cela est illustré sur la figure 4 ; la description peut également prendre la forme d'un tableau récapitulatif des valeurs des différents paramètres associés aux différents travaux réalisés, comme par exemple le tableau 1 ci-dessus ; la description peut également prendre la forme d'une représentation des positions de début et de fin des travaux réalisés, mesurées dans les trois dimensions dans un référentiel définis par trois axes X, Y, Z, comme cela est illustré à titre d'exemple sur la figure 5.

Optionnellement, le procédé 100 comprend en outre une étape de comparaison 104 des travaux réalisés avec un programme de travaux prévus, afin de déterminer un écart entre les travaux réalisés et les travaux prévus.

Optionnellement également, le procédé 100 comprend en outre une étape de transmission 105, à une unité d'affichage UI disposée localement sur l'engin de levage E ou à distance, de la description de l'au moins un travail réalisé produite au cours de l'étape de traitement 103, pour permettre un affichage et un suivi local des travaux réalisés.

Selon une possibilité, l'unité d'affichage UI comprend en outre une interface utilisateur permettant à un utilisateur d'interagir avec l'unité d'affichage Ul.

Ainsi, l'étape de traitement peut être réalisée localement sur l'unité de traitement local UT de l'engin de levage E, ou sur une unité de traitement distante UTD disposée sur le serveur distant S.

De même, l'étape d'affichage à des fins de suivi des travaux réalisés peut être réalisée localement sur l'unité d'affichage de l'engin de levage E, ou sur une unité d'affichage disposée à distance et par exemple associée au serveur distant S.

Ainsi, selon un aspect, l'invention concerne un système de levage comprenant un engin de levage E et un serveur distant S, l'engin de levage E comprenant une unité de contrôle-commande C2 de l'engin de levage E, l'engin de levage E comprenant en outre une unité de collecte UC configurée pour réaliser une étape de collecte 101 pendant au moins une période de temps d'informations en provenance de l'unité de contrôle-commande C2 de l'engin de levage E, l'unité de collecte UC étant configurée pour transmettre les informations collectées à une unité de traitement distante UTD disposée sur le serveur distant S, l'unité de traitement distante UTD étant configurée pour réaliser une étape de traitement 103 des informations collectées par l'unité de collecte UC pour déterminer un travail réalisé par l'engin de levage E pendant l'au moins une période de temps, le travail réalisé relevant d'au moins une catégorie de travail réalisé T1, T2, T3, T4, T5, T6, et pour déterminer au moins un paramètre associé à l'au moins un travail réalisé et/ou à l'au moins une catégorie de travail réalisé T1, T2, T3, T4, T5, T6.

Selon un autre aspect, l'invention concerne également un engin de levage E, comprenant une unité de contrôle-commande C2 de l'engin de levage E et une unité de traitement locale UT disposée sur l'engin de levage E, l'engin de levage E comprenant en outre une unité de collecte UC configurée pour réaliser une étape de collecte 101 pendant au moins une période de temps des informations en provenance de l'unité de contrôle-commande C2 de l'engin de levage E, l'unité de collecte UC étant configurée pour transmettre les informations collectées à l'unité de traitement locale UT disposée sur l'engin de levage E et/ou à une unité de traitement distante UTD, l'unité de traitement locale UT et/ou l'unité de traitement distante UTD étant configurée(s) pour réaliser une étape de traitement 103 des informations collectées par l'unité de collecte UC pour déterminer un travail réalisé par l'engin de levage E pendant l'au moins une période de temps, le travail réalisé relevant d'au moins une catégorie de travail réalisé T1, T2, T3, T4, T5, T6, et pour déterminer au moins un paramètre associé à l'au moins un travail réalisé et/ou à l'au moins une catégorie de travail réalisé T1, T2, T3, T4, T5, T6.

Selon un exemple de réalisation, l'unité de traitement locale UT et/ou l'unité de traitement distant UTD est/sont configurée(s) pour mettre en oeuvre un algorithme d'intelligence artificielle entraîné au cours d'une phase d'apprentissage pour réaliser l'étape de traitement 103 au cours d'une phase prédictive, en utilisant au moins une information contextuelle pour déterminer le travail réalisé et/ou la catégorie de travail réalisé et pour produire une description des travaux réalisés par l'engin de levage E.

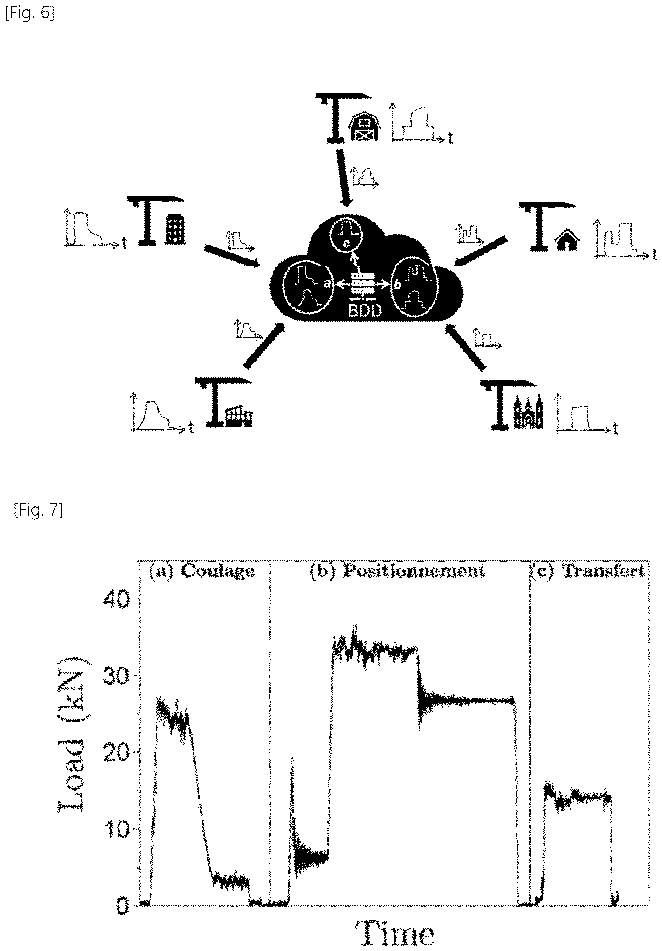

Selon une possibilité, la phase d'apprentissage de l'algorithme d'intelligence artificielle comprend une phase de collecte de données issues des unités de contrôle-commande d'engins de levage fonctionnant sur différents chantiers, comme cela est représenté à la figure 6.

Selon une possibilité, la phase de collecte permet de collecter des données représentatives des différents signaux de charge correspondant à chaque engin de levage présent sur chacun des chantiers considérés, ce qui permet de constituer et d'enrichir en continue une base de données distante BDD avec une quantité importante de signaux de charge.

De même, la phase de collecte peut, selon une possibilité, permettre de collecter des informations contextuelles, lesquelles peuvent également venir enrichir une base de données distante.

Un tel enrichissement permet d'extraire et de déterminer différentes allures de signal de charge, chacune desdites allures étant représentatives d'une catégorie de travail réalisé.

Ainsi, la phase d'apprentissage de l'algorithme d'intelligence artificielle permet de déterminer au moins une allure de signal de charge modèle, laquelle est représentative d'une catégorie de travail réalisé.

Par exemple et comme représenté sur la figure 7 dans laquelle l'axe des abscisses est représentatif d'une durée et l'axe des ordonnées est exprimé en kilo Newton (kN), une première allure a de signal de charge est représentative d'un coulage de béton, une deuxième allure b de signal de charge est représentative d'un positionnement d'un type de charge, et une troisième allure c de signal de charge est représentative d'un transfert d'un type de charge.

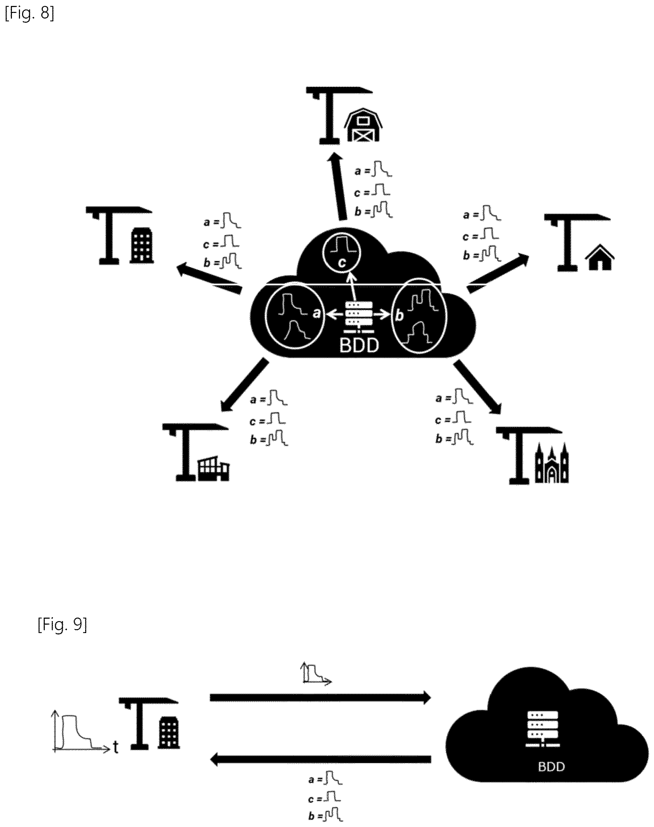

Une fois déterminées, les différentes allures de signal de charge modèles, ou allures types a, b, c peuvent être communiquées aux unités de traitement locale/distantes de chaque engin de levage, comme cela est représenté à la figure 8. Cela permet à chaque unité de traitement locale/distante de disposer des différentes allures modèles de signal de charge, afin de pouvoir reconnaître, via une étape de comparaison d'allures via un calcul de distance basé sur une déformation temporelle dynamique, puis de classifier le signal de charge de l'engin de levage correspondant selon l'une des catégories de travail réalisé.

## Revendications

1. Procédé (100) automatisé pour établir un inventaire des catégories de travaux (T1, T2, T3, T4, T5, T6) réalisés pendant différentes périodes de temps par un engin de levage (E), le procédé comprenant les étapes suivantes :
- une étape de collecte (101) pendant au moins une période de temps, par une unité de collecte (UC), d'informations en provenance d'une unité de contrôle-commande (C2) de l'engin de levage (E) ;
- une étape de traitement (103), par une unité de traitement locale (UT) et/ou une unité de traitement distante (UTD), des informations collectées par l'unité de collecte (UC) pour déterminer un travail réalisé par l'engin de levage (E) pendant l'au moins une période de temps, le travail réalisé relevant d'au moins une catégorie de travail réalisé (T1, T2, T3, T4, T5, T6), et pour déterminer au moins un paramètre associé à l'au moins un travail réalisé et/ou à l'au moins une catégorie de travail réalisé (T1, T2, T3, T4, T5, T6)
dans lequel l'étape de traitement (103) comprend une mise en oeuvre par l'unité de traitement locale (UT) et/ou l'unité de traitement distante (UTD) d'un algorithme d'intelligence artificielle entraîné au cours d'une phase d'apprentissage pour réaliser au cours d'une phase prédictive l'étape de traitement (103),
dans lequel l'algorithme d'intelligence artificielle utilise au moins une information contextuelle pour déterminer le travail réalisé et/ou la catégorie de travail réalisé, l'information contextuelle étant au moins l'une parmi un temps de levage, une charge maximale, une vitesse maximale, une position d'un point de prise de la charge et une position d'un point de dépose de la charge, une localisation d'un point de livraison, une localisation d'une zone de stockage.

2. Procédé (100) selon la revendication 1, dans lequel les informations collectées comprennent au moins l'un parmi un signal de charge, représentatif d'une masse d'une charge levée par l'engin de levage, un signal de position dans l'espace d'un crochet (C1) de l'engin de levage, un signal de vitesse représentatif d'une variation des variateurs de fréquence et un signal représentatif d'un état électrique de l'engin de levage.

3. Procédé (100) selon la revendication 2, dans lequel un signal de charge issu de l'étape de collecte est comparé à un ensemble de signaux modèles déterminés par une phase d'apprentissage de l'algorithme d'intelligence artificielle.

4. Procédé (100) selon l'une des revendications précédentes, dans lequel l'au moins une catégorie de travail réalisé pendant l'au moins une période de temps comprend au moins l'une parmi un coulage de béton, un transfert d'un type de charge, un positionnement d'un type de charge, un mouvement à vide, un déchargement d'un camion de matériaux.

5. Procédé (100) selon l'une des revendications précédentes, dans lequel le type de charge comprend au moins l'une parmi une benne à béton, une benne à gravats, un ou plusieurs matériels de construction, un ou plusieurs éléments de coffrage, un ou plusieurs éléments de ferraillage de béton, un élément préfabriqué.

6. Procédé (100) selon l'une des revendications précédentes, dans lequel l'au moins un paramètre associé à l'au moins une catégorie de travail réalisé (T1, T2, T3, T4, T5, T6) comprend au moins l'un parmi une durée d'un travail réalisé relevant de ladite au moins une catégorie de travail (T1, T2, T3, T4, T5, T6), une masse d'une charge levée au cours d'un travail réalisé relevant de l'au moins une catégorie de travail (T1, T2, T3, T4, T5, T6), un mouvement d'une charge levée au cours d'un travail réalisé relevant de l'au moins une catégorie de travail (T1, T2, T3, T4, T5, T6), une durée moyenne des travaux réalisés, pendant différentes périodes de temps, relevant de ladite catégorie de travail (T1, T2, T3, T4, T5, T6), une durée maximum des travaux réalisés, pendant différentes périodes de temps, relevant de ladite catégorie de travail (T1, T2, T3, T4, T5, T6), une durée minimum des travaux réalisés, pendant différentes périodes de temps, relevant de ladite catégorie de travail (T1, T2, T3, T4, T5, T6), une masse minimum levée au cours des travaux réalisés, pendant différentes périodes de temps, relevant de ladite catégorie de travail (T1, T2, T3, T4, T5, T6), une masse maximum levée au cours des travaux réalisés, pendant différentes périodes de temps, relevant de ladite catégorie de travail (T1, T2, T3, T4, T5, T6).

7. Procédé (100) selon l'une des revendications précédentes, dans lequel l'étape de traitement (103) produit une description des travaux réalisés par l'engin de levage (E), la description prenant au moins une forme parmi un graphique représentant l'au moins un travail réalisé, selon la catégorie du travail réalisé (T1, T2, T3, T4, T5, T6), en fonction d'un temps représenté selon un axe du temps, un diagramme de type camembert représentatif d'une importance relative de l'au moins un paramètre associé à l'au moins une catégorie du travail (T1, T2, T3, T4, T5, T6), un tableau récapitulatif de valeurs de l'au moins un paramètre associé à l'au moins une catégorie de travail (T1, T2, T3, T4, T5, T6), une représentation en trois dimensions d'un point de début et de fin d'au moins un travail réalisé relevant d'au moins une catégorie de travail (T1, T2, T3, T4, T5, T6).

8. Procédé (100) selon l'une des revendications précédentes, comprenant en outre une étape de comparaison (104) de l'au moins un travail réalisé relevant de l'au moins une catégorie de travail réalisé (T1, T2, T3, T4, T5, T6) avec au moins un travail prévu, afin de déterminer un écart entre l'au moins un travail réalisé et l'au moins un travail prévu.

9. Procédé (100) selon l'une des revendications précédentes, dans lequel l'étape de traitement (103) des informations collectées est réalisée localement sur l'engin de levage.

10. Procédé (100) selon l'une des revendications précédentes, comprenant en outre une étape de transmission (102) des informations collectées à une unité de traitement distante (UTD) disposée sur un serveur distant (S) configuré pour mettre en oeuvre l'étape de traitement (103) des informations collectées.

11. Procédé (100) selon la revendication précédente, en tant qu'elle dépend de la revendication 9, comprenant en outre une étape de transmission (105), à une unité d'affichage disposée localement sur l'engin de levage (E) ou à distance, de la description de l'au moins un travail réalisé produite au cours de l'étape de traitement (103), pour permettre un affichage et un suivi local des travaux réalisés.

12. Système de levage comprenant un engin de levage (E) et un serveur distant (S), l'engin de levage (E) comprenant une unité de contrôle-commande (C2) de l'engin de levage (E), l'engin de levage (E) comprenant en outre une unité de collecte (UC) configurée pour réaliser une étape de collecte (101) pendant au moins une période de temps des informations en provenance de l'unité de contrôle-commande (C2) de l'engin de levage (E), l'unité de collecte (UC) étant configurée pour transmettre les informations collectées à une unité de traitement locale (UT) et/ou une unité de traitement distante (UTD) disposée sur le serveur distant (S), l'unité de traitement locale (UT) et/ou l'unité de traitement distante (UTD) étant configurée(s) pour réaliser une étape de traitement (103) des informations collectées pour déterminer un travail réalisé par l'engin de levage (E) pendant l'au moins une période de temps, le travail réalisé relevant d'au moins une catégorie de travail (T1, T2, T3, T4, T5, T6), et pour déterminer au moins un paramètre associé à l'au moins un travail réalisé et/ou à l'au moins une catégorie de travail réalisé (T1, T2, T3, T4, T5, T6), dans lequel l'étape de traitement (103) comprend une mise en oeuvre par l'unité de traitement locale (UT) et/ou l'unité de traitement distante (UTD) d'un algorithme d'intelligence artificielle entraîné au cours d'une phase d'apprentissage pour réaliser au cours d'une phase prédictive l'étape de traitement (103), et dans lequel l'algorithme d'intelligence artificielle utilise au moins une information contextuelle pour déterminer le travail réalisé et/ou la catégorie de travail réalisé, l'information contextuelle étant au moins l'une parmi un temps de levage, une charge maximale, une vitesse maximale, une position d'un point de prise de la charge et une position d'un point de dépose de la charge, une localisation d'un point de livraison, une localisation d'une zone de stockage.

13. Engin de levage (E), comprenant une unité de contrôle-commande (C2) de l'engin de levage (E) et une unité de traitement locale (UT) disposée sur l'engin de levage (E), l'engin de levage (E) comprenant en outre une unité de collecte (UC) configurée pour réaliser une étape de collecte (101) pendant au moins une période de temps des informations en provenance de l'unité de contrôle-commande (C2) de l'engin de levage (E), l'unité de collecte (UC) étant configurée pour transmettre les informations collectées à l'unité de traitement locale (UT), disposée sur l'engin de levage (E), l'unité de traitement locale (UT) étant configurée pour réaliser une étape de traitement (103) des informations collectées pour déterminer un travail réalisé par l'engin de levage (E) pendant l'au moins une période de temps, le travail réalisé relevant d'au moins une catégorie de travail (T1, T2, T3, T4, T5, T6), et pour déterminer au moins un paramètre associé à l'au moins un travail réalisé et/ou à l'au moins une catégorie de travail réalisé (T1, T2, T3, T4, T5, T6), dans lequel l'étape de traitement (103) comprend une mise en oeuvre par l'unité de traitement locale (UT) d'un algorithme d'intelligence artificielle entraîné au cours d'une phase d'apprentissage pour réaliser au cours d'une phase prédictive l'étape de traitement (103), et dans lequel l'algorithme d'intelligence artificielle utilise au moins une information contextuelle pour déterminer le travail réalisé et/ou la catégorie de travail réalisé, l'information contextuelle étant au moins l'une parmi un temps de levage, une charge maximale, une vitesse maximale, une position d'un point de prise de la charge et une position d'un point de dépose de la charge, une localisation d'un point de livraison, une localisation d'une zone de stockage.
